# EUROPEAN PATENT APPLICATION

(11) **EP 4 629 774 A1**
(43) Date of publication of application: **08.10.2025**
(21) Application number: 24215023.3
(22) Date of filing: 25.11.2024
(51) Int. Cl.: H10D 30/60, H10D 64/68, H10D 30/67, H10D 30/69, H10D 84/01

(54) **SEMICONDUCTOR DEVICE**

(30) Priority: 04.04.2024 KR 20240046078
(71) Applicant: Samsung Electronics Co., Ltd., Suwon-si, Gyeonggi-do 16677 (KR)
(72) Inventor: SONG, Hee Chan, Suwon-si, Gyeonggi-do 16677 (KR); KIM, Dohyung, Suwon-si, Gyeonggi-do 16677 (KR); LEE, Dongsoo, Suwon-si, Gyeonggi-do 16677 (KR)
(74) Representative: Kuhnen & Wacker Patent- und Rechtsanwaltsbüro PartG mbB

(57) **Abstract**

Disclosed is a semiconductor device comprising a first channel region, a first dielectric structure on the first channel region, a first metal pattern spaced apart from the first dielectric structure, and a first dipole structure between the first metal pattern and the first dielectric structure. The first dipole structure includes a first dipole layer and a second dipole layer. The first dipole layer includes a first dipole element. The second dipole layer includes a second dipole element different from the first dipole element. A maximum oxidation number of the first dipole element is different from a maximum oxidation number of the second dipole element.

## Description

### CROSS-REFERENCE TO RELATED APPLICATIONS

This U.S. nonprovisional application claims priority under 35 U.S.C. § 119 to Korean Patent Application No. 10-2024-0046078 filed on April 4, 2024 in the Korean Intellectual Property Office, the disclosure of which is hereby incorporated by reference in its entirety.

### BACKGROUND OF THE INVENTION

The present inventive concepts relate to a semiconductor device, and more particularly, to a semiconductor device including a dipole structure.

A semiconductor device attracts attention as an essential element in the electronics industry because of its properties such as compactness, multi-functionality, and/or low manufacturing cost. Semiconductor devices may encompass semiconductor memory devices storing logic data, semiconductor logic devices processing operations of logic data, and hybrid semiconductor devices having both memory and logic elements.

Recently, high speed and low consumption of electronic products have required that semiconductor devices embedded in the electronic products should have high operating speed and/or lower operating voltage. However, an increase in integration of semiconductor devices may cause a reduction in electrical properties and production yield of semiconductor devices. Therefore, many studies have been conducted to increase electrical properties and production yield of semiconductor devices.

### SUMMARY OF THE INVENTION

Some embodiments of the present inventive concepts provide a semiconductor device with increased reliability and improved electrical properties.

According to some embodiments of the present inventive concepts, a semiconductor device may comprise: a first channel region; a first dielectric structure on the first channel region; a first metal pattern spaced apart from the first dielectric structure; and a first dipole structure between the first metal pattern and the first dielectric structure. The first dipole structure may include a first dipole layer and a second dipole layer. The first dipole layer may include a first dipole element. The second dipole layer may include a second dipole element different from the first dipole element. A maximum oxidation number of the first dipole element may be different from a maximum oxidation number of the second dipole element.

According to some embodiments of the present inventive concepts, a semiconductor device may comprise: a channel region; a gate dielectric layer on the channel region; a high-k dielectric layer on the gate dielectric layer; a first metal pattern spaced apart from the high-k dielectric layer; and a dipole structure between the first metal pattern and the high-k dielectric layer. The first metal pattern may include a metal compound. The dipole structure may include: a first dipole layer that includes a first dipole element; and a second dipole layer that includes a second dipole element. The first dipole element and the second dipole element may be different from each other.

According to some embodiments of the present inventive concepts, a semiconductor device may comprise: a channel region; a gate dielectric layer on the channel region; a high-k dielectric layer on the gate dielectric layer; a first metal pattern spaced apart from the high-k dielectric layer; a dipole structure between the first metal pattern and the high-k dielectric layer; and a conductive structure on the first metal pattern. The conductive structure may include polysilicon. The first metal pattern may include a metal compound. The dipole structure may include: a first dipole layer that includes a first dipole element; and a second dipole layer that includes a second dipole element. A maximum oxidation number of the first dipole element may be different from a maximum oxidation number of the second dipole element.

### BRIEF DESCRIPTION OF DRAWINGS

FIG. 1 illustrates a cross-sectional view showing a semiconductor device according to some embodiments.
FIG. 2A illustrates an enlarged view showing section E1 of FIG. 1.
FIG. 2B illustrates an energy band diagram of a semiconductor device depicted in FIG. 2A.
FIG. 3A illustrates an enlarged cross-sectional view showing a semiconductor device according to some embodiments.
FIG. 3B illustrates an energy band diagram of a semiconductor device depicted in FIG. 3A.
FIG. 4 illustrates a cross-sectional view showing a semiconductor device according to some embodiments.
FIG. 5 illustrates an enlarged view showing section E2 of FIG. 4.
FIG. 6 illustrates an enlarged cross-sectional view showing a semiconductor device according to some embodiments.
FIG. 7 illustrates a cross-sectional view showing a semiconductor device according to some embodiments.
FIG. 8 illustrates a cross-sectional view showing a semiconductor device according to some embodiments.
FIG. 9 illustrates a cross-sectional view showing a semiconductor device according to some embodiments.
FIG. 10 illustrates a cross-sectional view showing a semiconductor device according to some embodiments.
FIGS. 11A and 11B illustrate cross-sectional views showing a semiconductor device according to some embodiments.
FIG. 11C illustrates an enlarged view showing section E3 of FIG. 11B.
FIGS. 12A and 12B illustrate cross-sectional views showing a semiconductor device according to some embodiments.
FIG. 12C illustrates an enlarged view showing section E4 of FIG. 12B.

### DETAILED DESCRIPTION

The following will describe a semiconductor device and a method of fabricating the same according to some embodiments of the present inventive concepts in conjunction with the accompanying drawings.

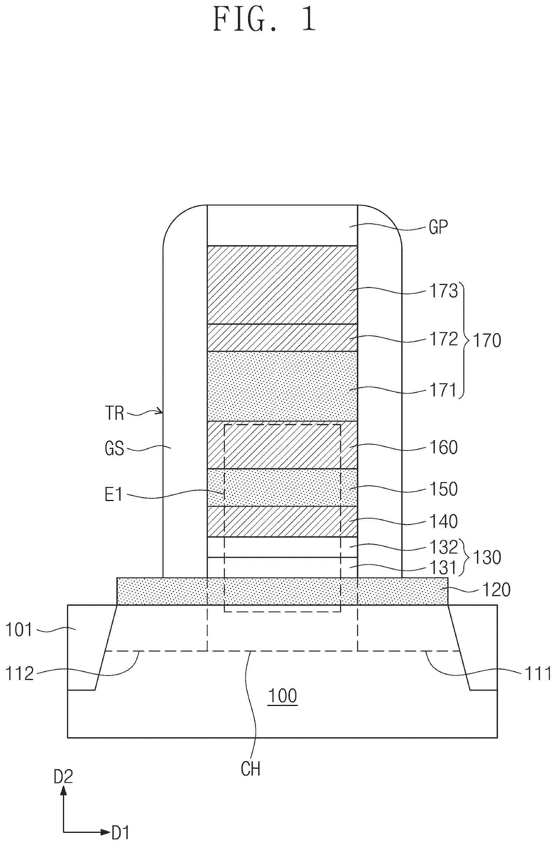

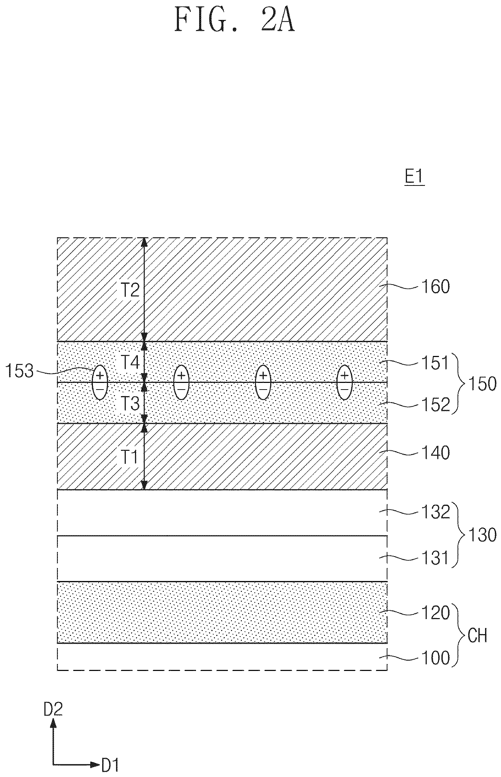

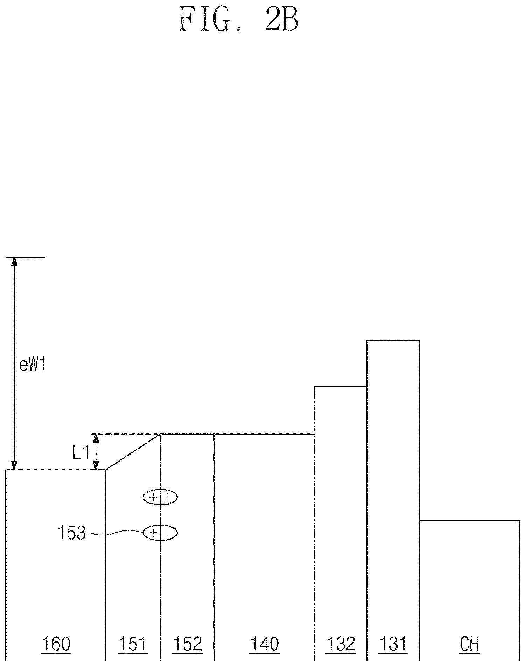

FIG. 1 illustrates a cross-sectional view showing a semiconductor device according to some embodiments. FIG. 2A illustrates an enlarged view showing section E1 of FIG. 1. FIG. 2B illustrates an energy band diagram of a semiconductor device depicted in FIG. 2A.

Referring to FIG. 1, a semiconductor device may include a substrate 100. A top surface of the substrate 100 may be parallel to a first direction D1. In some embodiments, the substrate 100 may be a semiconductor substrate. For example, the substrate 100 may include silicon (Si), germanium (Ge), silicon-germanium (SiGe), gallium phosphide (GaP), or gallium arsenide (GaAs). In some embodiments, the substrate 100 may be a semiconductor-on-insulator (SOI) substrate. The substrate 100 may be doped with impurities having a first conductivity type. For example, the substrate 100 may be doped with n-type impurities.

The substrate 100 may be provided with device isolation layers 101 therein. The device isolation layers 101 may include a dielectric material.

A transistor TR may be provided on the substrate 100. The transistor TR may be provided between the device isolation layers 101. The transistor TR may include a portion of the substrate 100, a semiconductor layer 120, a dielectric structure 130, a first metal pattern 140, a dipole structure 150, a second metal pattern 160, a conductive structure 170, gate spacers GS, and a gate capping pattern GP. In some embodiments, the transistor TR may be a p-channel metal-oxide-semiconductor field-effect transistor (PMOSFET).

The semiconductor layer 120, the dielectric structure 130, the first metal pattern 140, the dipole structure 150, the second metal pattern 160, the conductive structure 170, and the gate capping pattern GP may be sequentially stacked along a second direction D2 on the substrate 100. The second direction D2 may intersect the first direction D1. For example, the first direction D1 and the second direction D2 may be a horizontal direction and a vertical direction, respectively, that are orthogonal to each other.

The transistor TR may include a first source/drain region 111, a second source/drain region 112, and a channel region CH. The channel region CH may be disposed between the first source/drain region 111 and the second source/drain region 112. Each of the first source/drain region 111, the second source/drain region 112, and the channel region CH may include a portion of the substrate 100 and a portion of the semiconductor layer 120.

The first source/drain region 111 and the second source/drain region 112 may be doped with impurities having a second conductivity type different from the first conductivity type. For example, the first source/drain region 111 and the second source/drain region 112 may be doped with p-type impurities.

The semiconductor layer 120 may include a semiconductor material different from that of the substrate 100. For example, the substrate 100 may include silicon, and the semiconductor layer 120 may include silicon-germanium. In some embodiments, the semiconductor layer 120 may be a monocrystalline semiconductor layer. In some embodiments, a lattice constant of the semiconductor layer 120 may be greater than that of the substrate 100.

The dielectric structure 130 may include a gate dielectric layer 131 on the semiconductor layer 120 and a high-k dielectric layer 132 on the gate dielectric layer 131. The gate dielectric layer 131 may include a dielectric material. For example, the gate dielectric layer 131 may be a compound including at least one selected from Si, Hf, Zr, In, Ga, and Zn and at least one selected from O and N. The gate dielectric layer 131 may be, for example, a silicon oxide layer.

The high-k dielectric layer 132 may include a material different from that of the gate dielectric layer 131. The high-k dielectric layer 132 may have a dielectric constant greater than that of the gate dielectric layer 131. The high-k dielectric layer 132 may have a material whose dielectric constant is greater than that of silicon oxide. For example, the high-k dielectric layer 132 may be a compound including at least one selected from Si, Hf, Zr, In, Ga, and Zn and at least one selected from O and N. The high-k dielectric layer 132 may be, for example, a HfSiON layer.

The first metal pattern 140 may include a metal compound. For example, the first metal pattern 140 may include at least one selected from titanium (Ti), molybdenum (Mo), aluminum (Al), and tungsten (W) and at least one selected from carbon (C), oxygen (O), and nitrogen (N). The first metal pattern 140 may be, for example, a titanium nitride (TiN) layer.

The first metal pattern 140 may have a work function capable of allowing the transistor TR to operate. For example, the transistor TR may be a PMOSFET, and the first metal pattern 140 may have a p-type work function suitable for the PMOSFET. In some embodiments, the work function of the first metal pattern 140 may be greater than an electron affinity of the channel region CH, and may be less than a sum of the electron affinity and a bandgap energy of the channel region CH. In some embodiments, the work function of the first metal pattern 140 may be greater than a mid-gap work function of the channel region CH.

The second metal pattern 160 may be spaced apart from the high-k dielectric layer 132 of the dielectric structure 130. The second metal pattern 160 may include a metal compound. For example, the second metal pattern 160 may include at least one selected from Ti, Mo, Al, and W and at least one selected from C, O, and N. The second metal pattern 160 may be, for example, a TiN layer. In some embodiments, a work function of the second metal pattern 160 may be greater than the electron affinity of the channel region CH, and may be less than a sum of the electron affinity and the bandgap energy of the channel region CH.

In some embodiments, the work function of the second metal pattern 160 may be less than the work function of the first metal pattern 140. In some embodiments, the work function of the second metal pattern 160 may be less than a mid-gap work function of the channel region CH. In some embodiments, the second metal pattern 160 and the first metal pattern 140 may include different materials from each other. In some embodiments, the second metal pattern 160 and the first metal pattern 140 may include the same material and have different compositions. The terms "first" and "second" are used herein merely for convenience of differentiating between various elements, and embodiments herein are not limited to these terms. For example, the second metal pattern 160 may also be referred to herein as a "first" metal pattern, and the first metal pattern 140 may also be referred to herein as a "second" metal pattern.

The conductive structure 170 may include a first conductive layer 171, a second conductive layer 172 on the first conductive layer 171, and a third conductive layer 173 on the second conductive layer 172. The first conductive layer 171 may be spaced apart from the dipole structure 150. The second metal pattern 160 may be disposed between the first conductive layer 171 and the dipole structure 150.

The first conductive layer 171 may include a conductive material different from those of the dipole structure 150, the first metal pattern 140, the second metal pattern 160, the second conductive layer 172, and the third conductive layer 173. The first conductive layer 171 may include polysilicon. For example, the first conductive layer 171 may include polysilicon doped with impurities (e.g., n-type impurities).

The second conductive layer 172 may be a barrier layer. The second conductive layer 172 may be, for example, a titanium silicon nitride (TiSiN) layer. The third conductive layer 173 may be, for example, a tungsten (W) layer.

The gate capping pattern GP may be provided on the third conductive layer 173 of the conductive structure 170. The gate capping pattern GP may include a dielectric material.

The gate spacers GS may be provided on opposite sidewalls of the dielectric structure 130, the first metal pattern 140, the dipole structure 150, the second metal pattern 160, and the conductive structure 170. The gate spacers GS may include a dielectric material.

Referring to FIGS. 2A and 2B, the dipole structure 150 may be disposed between the first metal pattern 140 and the second metal pattern 160. The dipole structure 150 may include a first dipole layer 151 and a second dipole layer 152. The second dipole layer 152 may be provided on the first metal pattern 140. The first dipole layer 151 may be provided on the second dipole layer 152. A top surface of the first dipole layer 151 may be in contact with a bottom surface of the second metal pattern 160. A bottom surface of the second dipole layer 152 may be in contact with a top surface of the first metal pattern 140. The first dipole layer 151 may include a material different from that of the first metal pattern 140 and the second metal pattern 160. The second dipole layer 152 may include a material different from that of the first metal pattern 140 and the second metal pattern 160. The first dipole layer 151 may include a material different from that of the second dipole layer 152.

The first dipole layer 151 may include a first dipole element. The first dipole element may be a dipole-inducing material or a dipole-forming material. The first dipole element may be metal or metalloid. For example, the first dipole element may be Ti, Al, zirconium (Zr), hafnium (Hf), magnesium (Mg), yttrium (Y), lanthanum (La), lutetium (Lu), strontium (Sr), Si, or Ge. The first dipole layer 151 may be a single layer including the first dipole element or a compound including the first dipole element. The compound may include oxygen (O) or nitrogen (N). For example, the first dipole layer 151 may be a Ti layer, a TiSiN layer, an SiN layer, a silicon oxide (SiO) layer, or a titanium oxide (TiO) layer. In some embodiments, the first dipole element may be different from metal included in the first metal pattern 140 and the second metal pattern 160.

The second dipole layer 152 may include a second dipole element. The second dipole element may be a dipole-inducing material or a dipole-forming material. The second dipole element may be metal or metalloid. The second dipole element may be an n-type dipole element. The n-type dipole element may form a dipole to decrease a threshold voltage of an n-channel MOSFET (NMOSFET) and to increase a threshold voltage of a PMOSFET. The second dipole element may be different (e.g., a different metal) from the first dipole element. A maximum oxidation number of the second dipole element may be different from (e.g., less than) that of the first dipole element. For example, when the first dipole element is Ti, Zr, Hf, Si, or Ge whose maximum oxidation number is four, the second dipole element may be Al, Mg, Y, La, Lu, or Sr whose maximum oxidation number is three or less. For example, when the first dipole element is Al, Y, La, or Lu whose maximum oxidation number is three, the second dipole element may be Mg or Sr whose maximum oxidation number is two. The second dipole layer 152 may be a single layer including the second dipole element or a compound including the second dipole element. The compound may include oxygen (O) or nitrogen (N). For example, the second dipole layer 152 may be an La layer or a lanthanum oxide (LaO) layer. In some embodiments, the first dipole layer 151 and the second dipole layer 152 may have a dielectric constant greater than that of silicon oxide. In some embodiments, the second dipole element may be different from metal included in the first metal pattern 140 and the second metal pattern 160.

As the maximum oxidation number of the second dipole element is less than that of the first dipole element, an interface dipole 153 may be formed between (e.g., at an interface of) the first dipole layer 151 and the second dipole layer 152. The interface dipole 153 may be formed to allow a positive charge to face the first dipole layer 151. The interface dipole 153 may cause an increase, as much as a first level L1 (FIG. 2B), in effective work function eW1 of a structure that includes the first metal pattern 140, the second dipole layer 152, the first dipole layer 151, and the second metal pattern 160. The interface dipole 153 may adjust a threshold voltage of the transistor TR.

A thickness T1 (FIG. 2A) in a second direction D2 of the first metal pattern 140 may be less than a thickness T2 in the second direction D2 of the second metal pattern 160. A thickness T3 in the second direction D2 of the second dipole layer 152 and a thickness T4 in the second direction D2 of the first dipole layer 151 may be less than the thickness T1 in the second direction D2 of the first metal pattern 140 and the thickness T2 in the second direction D2 of the second metal pattern 160. As the interface dipole 153 adjusts the threshold voltage of the transistor TR, the first metal pattern 140 may have a relatively small thickness and the transistor TR may have a relatively small size.

In some embodiments, the maximum oxidation number of the second dipole element of the second dipole layer 152 may be greater than that of the first dipole element of the first dipole layer 151. For example, when the second dipole element is Ti, Zr, Hf, Si, or Ge whose maximum oxidation number is four, the first dipole element may be Al, Mg, Y, La, Lu, or Sr whose maximum oxidation number is three or less. For example, when the second dipole element is Al, Y, La, or Lu whose maximum oxidation number is three, the first dipole element may be Mg or Sr whose maximum oxidation number is two.

As the maximum oxidation number of the second dipole element of the second dipole layer 152 is greater than that of the first dipole element of the first dipole layer 151, the interface dipole 153 may be formed to allow a positive charge to face the second dipole layer 152. The interface dipole may cause a reduction in effective work function of a structure that includes the first metal pattern 140, the second dipole layer 152, the first dipole layer 151, and the second metal pattern 160, and may adjust the threshold voltage of the transistor TR.

The semiconductor device according to some embodiments may include the dipole structure 150 including the first dipole layer 151 and the second dipole layer 152, and therefore the threshold voltage of the transistor TR may be adjusted.

In the semiconductor device according to some embodiments, the first dipole layer 151 may be provided to restrict or prevent the second dipole element of the second dipole layer 152 from diffusing downwardly below the first metal pattern 140. Therefore, it may be possible to restrict or prevent an increase in threshold voltage of the transistor TR due to diffusion of the second dipole element of the second dipole layer 152.

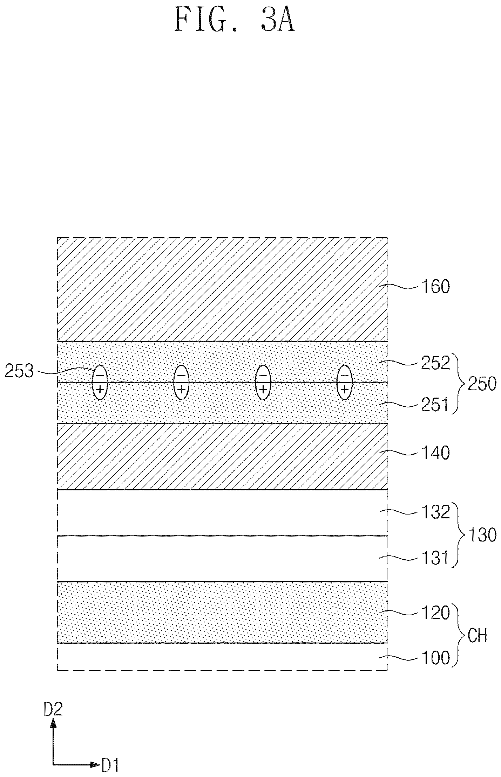

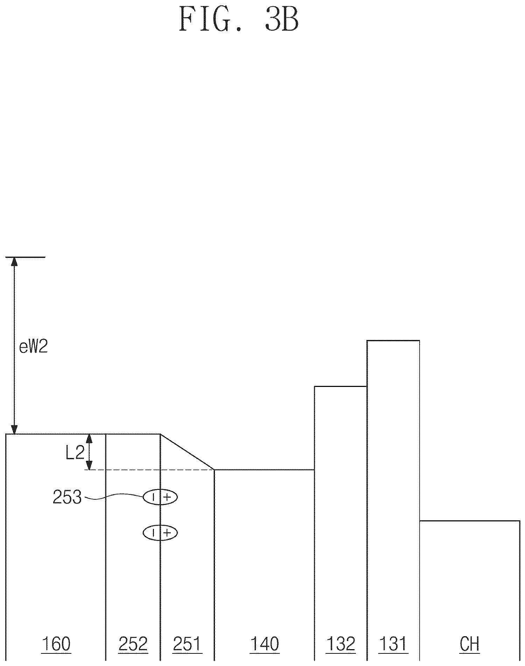

FIG. 3A illustrates an enlarged cross-sectional view showing a semiconductor device according to some embodiments. FIG. 3B illustrates an energy band diagram of a semiconductor device depicted in FIG. 3A. Except that discussed below, a semiconductor device of FIG. 3A may be similar to the semiconductor device of FIGS. 1 and 2A.

Referring to FIGS. 3A and 3B, a dipole structure 250 may include a first dipole layer 251 on the first metal pattern 140 and a second dipole layer 252 on the first dipole layer 251. A bottom surface of the first dipole layer 251 may be in contact with the top surface of the first metal pattern 140. A top surface of the second dipole layer 252 may be in contact with the bottom surface of the second metal pattern 160.

The first dipole layer 251 may include a first dipole element. The first dipole element may be metal or metalloid. For example, the first dipole element may be Ti, Al, Zr, Hf, Mg, Y, La, Lu, Sr, Si, or Ge. The first dipole layer 251 may be a single layer including the first dipole element or a compound including the first dipole element. For example, the first dipole layer 251 may be a Ti layer, a TiSiN layer, an SiN layer, an SiO layer, or a TiO layer.

The second dipole layer 252 may include a second dipole element. The second dipole element may be metal or metalloid. The second dipole element may be an n-type dipole element. The second dipole element may be different from the first dipole element. A maximum oxidation number of the second dipole element may be less than that of the first dipole element. The second dipole layer 252 may be a single layer including the second dipole element or a compound including the second dipole element. For example, the second dipole layer 252 may be an La layer or an LaO layer.

As the maximum oxidation number of the second dipole element is less than that of the first dipole element, an interface dipole 253 may be formed between (e.g., at an interface of) the first dipole layer 251 and the second dipole layer 252. The interface dipole 253 may be formed to allow a positive charge to face the first dipole layer 251. The interface dipole 253 may cause an increase, as much as a second level L2, in effective work function eW2 of a structure that includes the first metal pattern 140, the first dipole layer 251, the second dipole layer 252, and the second metal pattern 160. The interface dipole 253 may adjust a threshold voltage of the transistor TR.

In some embodiments, the maximum oxidation number of the second dipole element of the second dipole layer 252 may be greater than that of the first dipole element of the first dipole layer 251. As the maximum oxidation number of the second dipole element of the second dipole layer 252 is greater than that of the first dipole element of the first dipole layer 251, the interface dipole 253 may be formed to allow a positive charge to face the second dipole layer 252. The interface dipole 253 may cause an increase in effective work function of a structure that includes the first metal pattern 140, the second dipole layer 252, the first dipole layer 251, and the second metal pattern 160, and may adjust the threshold voltage of the transistor TR.

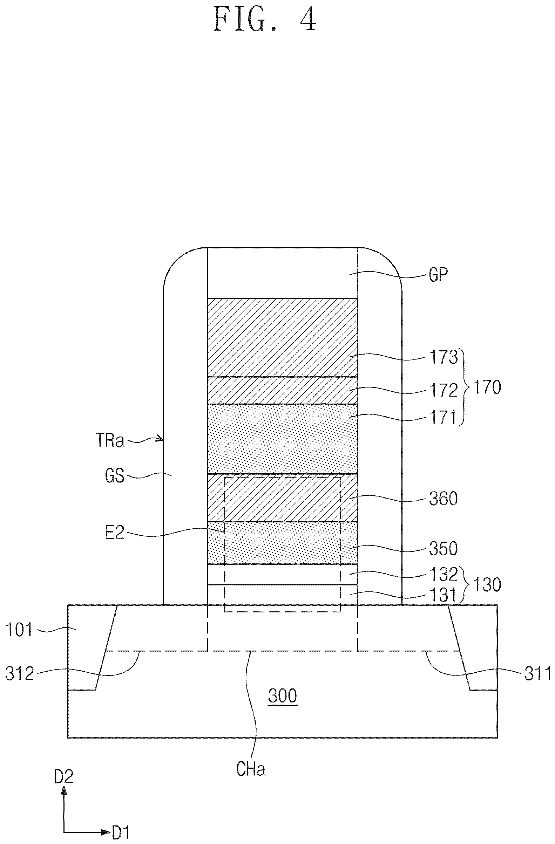

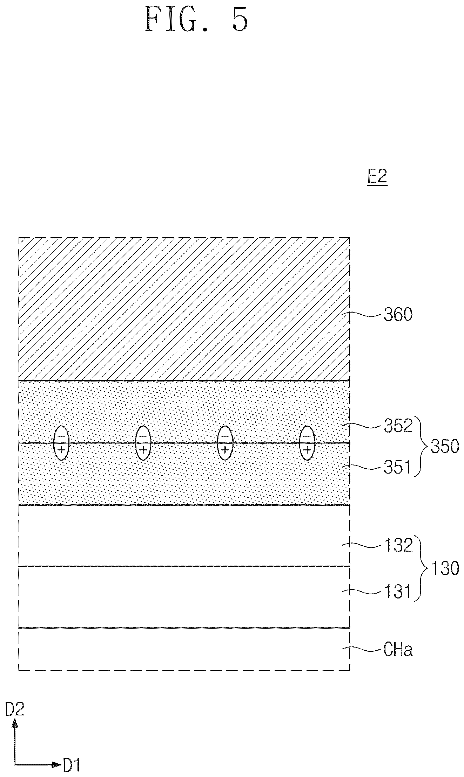

FIG. 4 illustrates a cross-sectional view showing a semiconductor device according to some embodiments. FIG. 5 illustrates an enlarged view showing section E2 of FIG. 4. Except that discussed below, a semiconductor device of FIGS. 4 and 5 may be similar to the semiconductor device of FIGS. 1 and 2A.

Referring to FIG. 4, a substrate 300 may be doped with impurities having a first conductivity type. For example, the substrate 300 may be doped with p-type impurities. A transistor TRa may be provided on the substrate 300. The transistor TRa may include a portion of the substrate 300, a dielectric structure 130, a dipole structure 350, a metal pattern 360, a conductive structure 170, gate spacers GS, and a gate capping pattern GP. In some embodiments, the transistor TRa may be an NMOSFET.

The transistor TRa may include a first source/drain region 311, a second source/drain region 312, and a channel region CHa. Each of the first source/drain region 311, the second source/drain region 312, and the channel region CHa may include a portion of the substrate 300.

The first source/drain region 311 and the second source/drain region 312 may be doped with impurities having a second conductivity type different from the first conductivity type. For example, the first source/drain region 311 and the second source/drain region 312 may be doped with n-type impurities.

The dielectric structure 130 may include a gate dielectric layer 131 on the substrate 300 and a high-k dielectric layer 132 on the gate dielectric layer 131.

The metal pattern 360 may include a metal compound. For example, the metal pattern 360 may include at least one selected from Ti, Mo, Al, and W and at least one selected from C, O, and N. The metal pattern 360 may be, for example, a TiN layer.

The metal pattern 360 may have a work function capable of allowing the transistor TRa to operate. For example, the transistor TRa may be an NMOSFET, and the metal pattern 360 may have an n-type work function suitable for the NMOSFET. In some embodiments, the work function of the metal pattern 360 may be greater than an electron affinity of the channel region CHa and less than a sum of the electron affinity and a bandgap energy of the channel region CHa. In some embodiments, the work function of the metal pattern 360 may be less than a mid-gap work function of the channel region CHa.

Referring to FIG. 5, the dipole structure 350 may include a first dipole layer 351 on the high-k dielectric layer 132 of the dielectric structure 130 and a second dipole layer 352 on the first dipole layer 351. A bottom surface of the first dipole layer 351 may be in contact with a top surface of the high-k dielectric layer 132 of the dielectric structure 130. A top surface of the second dipole layer 352 may be in contact with a bottom surface of the metal pattern 360.

The first dipole layer 351 may include a first dipole element. The first dipole element may be metal or metalloid. For example, the first dipole element may be Ti, Al, Zr, Hf, Mg, Y, La, Lu, Sr, Si, or Ge. The first dipole layer 351 may be a single layer including the first dipole element or a compound including the first dipole element. For example, the first dipole layer 351 may be a Ti layer, a TiSiN layer, an SiN layer, an SiO layer, or a TiO layer.

The second dipole layer 352 may include a second dipole element. The second dipole element may be metal or metalloid. The second dipole element may be an n-type dipole element. The second dipole element may be different from the first dipole element. A maximum oxidation number of the second dipole element may be less than that of the first dipole element. The second dipole layer 352 may be a single layer including the second dipole element or a compound including the second dipole element. For example, the second dipole layer 352 may be an La layer or an LaO layer.

As the maximum oxidation number of the second dipole element is less than that of the first dipole element, an interface dipole may be formed between the first dipole layer 351 and the second dipole layer 352, and a threshold voltage of the transistor TRa may be adjusted. In some embodiments, the maximum oxidation number of the second dipole element of the second dipole layer 352 may be greater than that of the first dipole element of the first dipole layer 351.

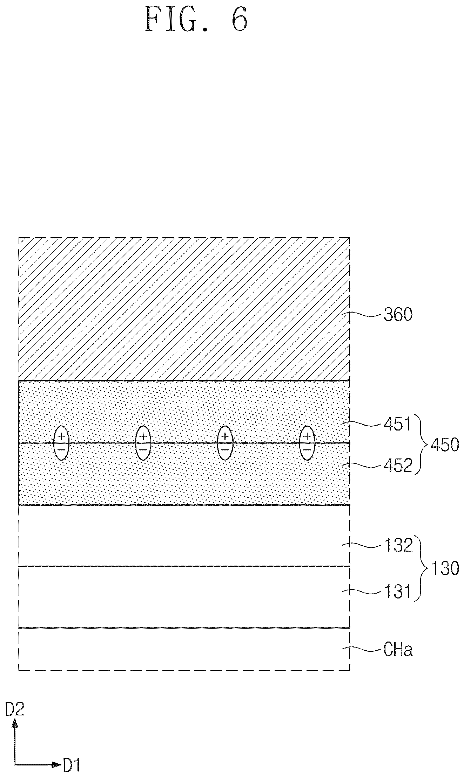

FIG. 6 illustrates an enlarged cross-sectional view showing a semiconductor device according to some embodiments. Except that discussed below, a semiconductor device of FIG. 6 may be similar to the semiconductor device of FIGS. 4 and 5.

Referring to FIG. 6, a dipole structure 450 may include a first dipole layer 451 and a second dipole layer 452. The second dipole layer 452 may be provided on the high-k dielectric layer 132 of the dielectric structure 130. The first dipole layer 451 may be provided on the second dipole layer 452. A bottom surface of the second dipole layer 452 may be in contact with the top surface of the high-k dielectric layer 132 of the dielectric structure 130. A top surface of the first dipole layer 451 may be in contact with the bottom surface of the metal pattern 360.

The first dipole layer 451 may include a first dipole element. The first dipole element may be metal or metalloid. For example, the first dipole element may be Ti, Al, Zr, Hf, Mg, Y, La, Lu, Sr, Si, or Ge. The first dipole layer 451 may be a single layer including the first dipole element or a compound including the first dipole element. For example, the first dipole layer 451 may be a Ti layer, a TiSiN layer, an SiN layer, an SiO layer, or a TiO layer.

The second dipole layer 452 may include a second dipole element. The second dipole element may be metal or metalloid. The second dipole element may be an n-type dipole element. The second dipole element may be different from the first dipole element. A maximum oxidation number of the second dipole element may be less than that of the first dipole element. The second dipole layer 452 may be a single layer including the second dipole element or a compound including the second dipole element. For example, the second dipole layer 452 may be an La layer or an LaO layer.

As the maximum oxidation number of the second dipole element is less than that of the first dipole element, an interface dipole may be formed between the first dipole layer 451 and the second dipole layer 452, and a threshold voltage of the transistor TRa may be adjusted. In some embodiments, the maximum oxidation number of the second dipole element of the second dipole layer 452 may be greater than that of the first dipole element of the first dipole layer 451.

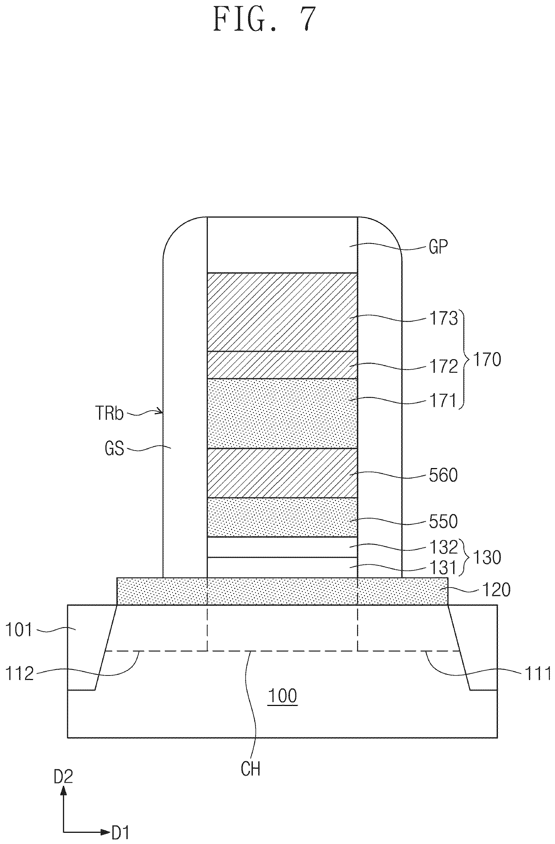

FIG. 7 illustrates a cross-sectional view showing a semiconductor device according to some embodiments. Except that discussed below, a semiconductor device of FIG. 7 may be similar to the semiconductor device of FIGS. 1 and 2A.

Referring to FIG. 7, a transistor TRb may be provided on a substrate 100. The transistor TRb may include a portion of the substrate 100, a semiconductor layer 120, a dielectric structure 130, a dipole structure 550, a metal pattern 560, a conductive structure 170, gate spacers GS, and a gate capping pattern GP. In some embodiments, the transistor TRb may be a PMOSFET.

The metal pattern 560 may include a metal compound. The metal pattern 560 may have a work function capable of allowing the transistor TRb to operate. For example, the transistor TRb may be a PMOSFET, and the metal pattern 560 may have a p-type work function suitable for the PMOSFET.

The dipole structure 550 may have a first dipole layer and a second dipole layer. The first dipole layer may include a first dipole element. The first dipole element may be metal or metalloid. For example, the first dipole element may be Ti, Al, Zr, Hf, Mg, Y, La, Lu, Sr, Si, or Ge. The first dipole layer may be a single layer including the first dipole element or a compound including the first dipole element. For example, the first dipole layer may be a Ti layer, a TiSiN layer, an SiN layer, an SiO layer, or a TiO layer.

The second dipole layer may include a second dipole element. The second dipole element may be metal or metalloid. The second dipole element may be a p-type dipole element. The p-type dipole element may form a dipole to decrease a threshold voltage of a PMOSFET and to increase a threshold voltage of an NMOSFET. The second dipole element may be different from the first dipole element. For example, among Ti, Al, Zr, Hf, Mg, Y, La, Lu, Sr, Si, and Ge, the second dipole element may be one different from that of the first dipole element. For example, the second dipole layer may an Al layer or an aluminum oxide (AlO) layer. A maximum oxidation number of the second dipole element may be different from that of the first dipole element. The maximum oxidation number of the second dipole element may be greater or less than that of the first dipole element.

In some embodiments, the first dipole layer may be in contact with a high-k dielectric layer 132 of the dielectric structure 130, and the second dipole layer may be in contact with the metal pattern 560. In some embodiments, the second dipole layer may be in contact with a high-k dielectric layer 132 of the dielectric structure 130, and the first dipole layer may be in contact with the metal pattern 560.

An interface dipole may be formed between the first and second dipole layers, and a threshold voltage of the transistor TRb may be adjusted.

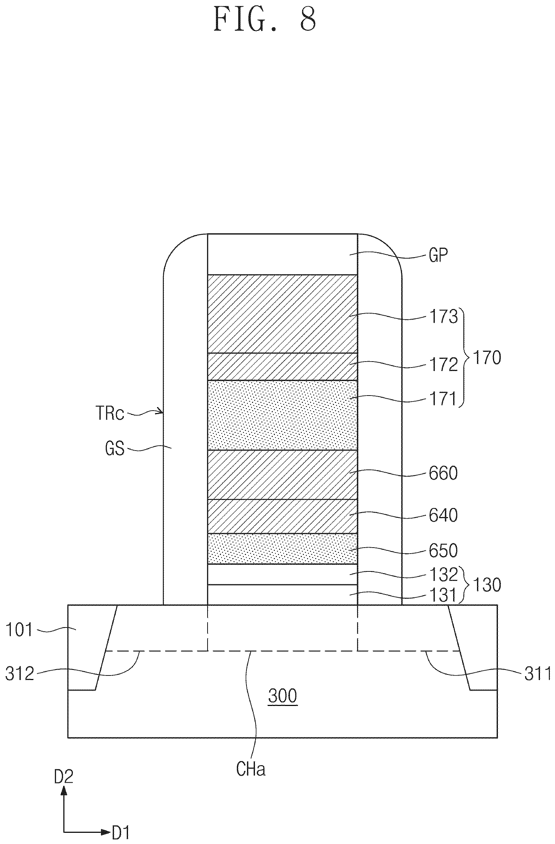

FIG. 8 illustrates a cross-sectional view showing a semiconductor device according to some embodiments. Except that discussed below, a semiconductor device of FIG. 8 may be similar to the semiconductor device of FIGS. 4 and 5.

Referring to FIG. 8, a transistor TRc may be provided on a substrate 300. The transistor TRc may include a portion of the substrate 300, a dielectric structure 130, a dipole structure 650, a first metal pattern 640, a second metal pattern 660, a conductive structure 170, gate spacers GS, and a gate capping pattern GP. In some embodiments, the transistor TRc may be an NMOSFET.

The dipole structure 650 may be provided on a high-k dielectric layer 132 of the dielectric structure 130. The first metal pattern 640 may be provided on the dipole structure 650. The second metal pattern 660 may be provided on the first metal pattern 640. A bottom surface of the dipole structure 650 may be in contact with a top surface of the high-k dielectric layer 132 of the dielectric structure 130. A top surface of the dipole structure 650 may be in contact with a bottom surface of the first metal pattern 640. A top surface of the first metal pattern 640 may be in contact with a bottom surface of the second metal pattern 660.

The first metal pattern 640 may include a metal compound. The first metal pattern 640 may have a work function capable of allowing the transistor TRc to operate. For example, the transistor TRc may be an NMOSFET, and the first metal pattern 640 may have an n-type work function suitable for the NMOSFET.

The second metal pattern 660 may include a metal compound. A work function of the second metal pattern 660 may be greater than that of the first metal pattern 640.

The dipole structure 650 may have a first dipole layer and a second dipole layer. The first dipole layer may include a first dipole element. The first dipole element may be metal or metalloid. For example, the first dipole element may be Ti, Al, Zr, Hf, Mg, Y, La, Lu, Sr, Si, or Ge. The first dipole layer may be a single layer including the first dipole element or a compound including the first dipole element. For example, the first dipole layer may be a Ti layer, a TiSiN layer, an SiN layer, an SiO layer, or a TiO layer.

The second dipole layer may include a second dipole element. The second dipole element may be metal or metalloid. The second dipole element may be a p-type dipole element. The second dipole element may be different from the first dipole element. For example, among Ti, Al, Zr, Hf, Mg, Y, La, Lu, Sr, Si, and Ge, the second dipole element may be one different from that of the first dipole element. For example, the second dipole layer may an Al layer or an AlO layer. A maximum oxidation number of the second dipole element may be different from that of the first dipole element. The maximum oxidation number of the second dipole element may be greater or less than that of the first dipole element.

In some embodiments, the first dipole layer may be in contact with the high-k dielectric layer 132 of the dielectric structure 130, and the second dipole layer may be in contact with the first metal pattern 640. In some embodiments, the second dipole layer may be in contact with the high-k dielectric layer 132 of the dielectric structure 130, and the first dipole layer may be in contact with the first metal pattern 640.

An interface dipole may be formed between the first and second dipole layers, and a threshold voltage of the transistor TRc may be adjusted.

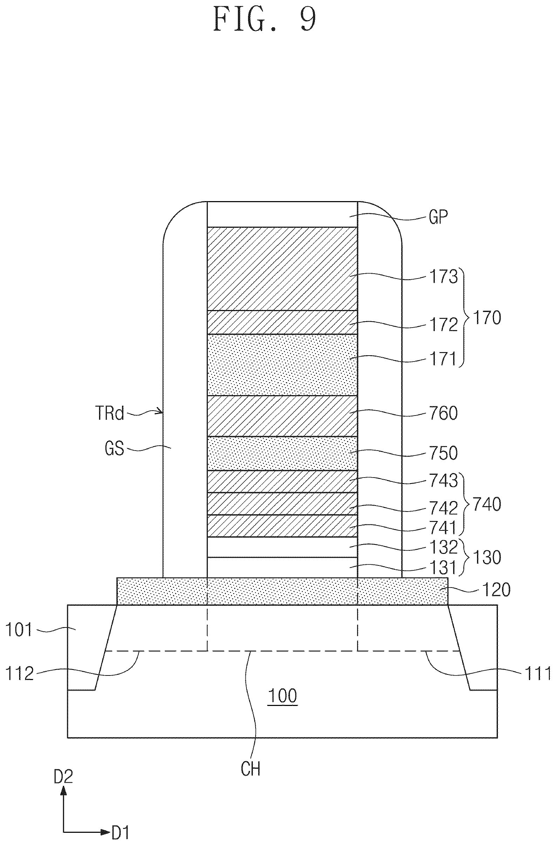

FIG. 9 illustrates a cross-sectional view showing a semiconductor device according to some embodiments. Except that discussed below, a semiconductor device of FIG. 9 may be similar to the semiconductor device of FIGS. 1 and 2A.

Referring to FIG. 9, a transistor TRd may include a portion of a substrate 100, a semiconductor layer 120, a dielectric structure 130, a first metal pattern 740, a dipole structure 750, a second metal pattern 760, a conductive structure 170, gate spacers GS, and a gate capping pattern GP. In some embodiments, the transistor TRd may be a PMOSFET.

The dipole structure 750 may have a structure similar to that of the dipole structure 150 discussed in FIG. 2A or that of the dipole structure 250 discussed in FIG. 3A.

The first metal pattern 740 may include a first metal layer 741, a second metal layer 742 on the first metal layer 741, and a third metal layer 743 on the second metal layer 742. The second metal layer 742 may include a material different from that of the first metal layer 741 and the third metal layer 743. For example, the first metal layer 741 and the third metal layer 743 may be a TiN layer, and the second metal layer 742 may be an Al layer.

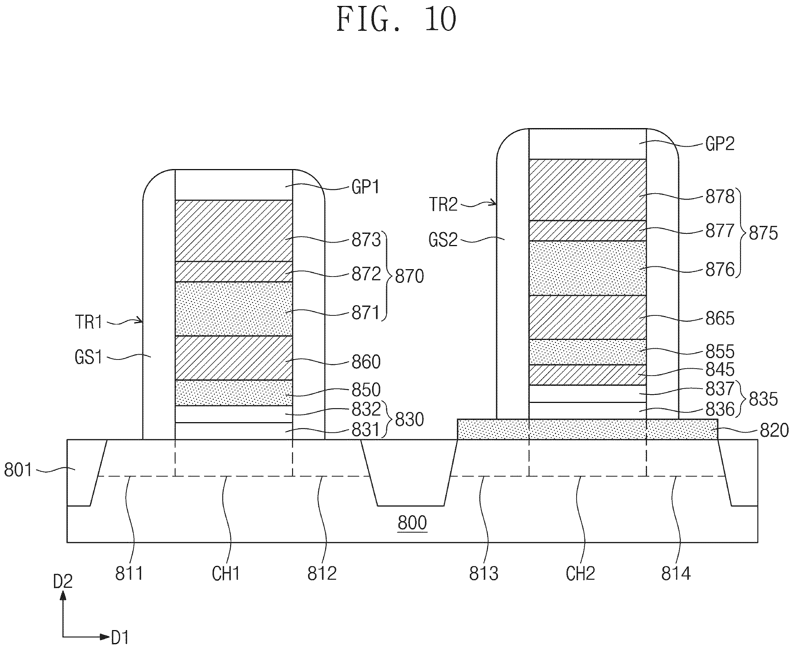

FIG. 10 illustrates a cross-sectional view showing a semiconductor device according to some embodiments.

Referring to FIG. 10, a semiconductor device may include a substrate 800. The substrate 800 may be provided with device isolation layers 801 therein.

A first transistor TR1 and a second transistor TR2 may be provided on the substrate 800. The first transistor TR1 may include a portion of the substrate 800, a first dielectric structure 830, a first dipole structure 850, a first metal pattern 860, a first conductive structure 870, first gate spacers GS1, and a first gate capping pattern GP1. In some embodiments, the first transistor TR1 may be an NMOSFET. The second transistor TR2 may include a portion of the substrate 800, a semiconductor layer 820, a second dielectric structure 835, a second metal pattern 845, a second dipole structure 855, a third metal pattern 865, a second conductive structure 875, second gate spacers GS2, and a second gate capping pattern GP2. In some embodiments, the second transistor TR2 may be a PMOSFET.

The first transistor TR1 may include a first channel region CH1, a first source/drain region 811, and a second source/drain region 812. The first channel region CH1 may be doped with, for example, p-type impurities. The second transistor TR2 may include a second channel region CH2, a third source/drain region 813, and a fourth source/drain region 814. The second channel region CH2 may be doped with, for example, n-type impurities.

The first dielectric structure 830 may include a first gate dielectric layer 831, a first high-k dielectric layer 832. The second dielectric structure 835 may include a second gate dielectric layer 836, a second high-k dielectric layer 837.

The first conductive structure 870 may include a first conductive layer 871, a second conductive layer 872, and a third conductive layer 873. The second conductive structure 875 may include a fourth conductive layer 876, a fifth conductive layer 877, and a sixth conductive layer 878.

The first dipole structure 850 may have a structure similar to that of the dipole structure 350 discussed in FIG. 5 or that of the dipole structure 450 discussed in FIG. 6. The second dipole structure 855 may have a structure similar to that of the dipole structure 150 discussed in FIG. 2A or that of the dipole structure 250 discussed in FIG. 3A.

The first dipole structure 850 may include a first dipole layer and a second dipole layer. The second dipole structure 855 may include a third dipole layer and a fourth dipole layer. The first and third dipole layers may include a first dipole element. The second and fourth dipole layers may include a second dipole element.

As the second transistor TR2 includes the second dipole structure 855, it may be possible to adjust a threshold voltage of the second transistor TR2 and to omit layers for adjusting the threshold voltage of the second transistor TR2. Therefore, a height of the second transistor TR2 may be relatively reduced, and a difference in height between the first and second transistors TR1 and TR2 may be reduced/minimized, with the result that a subsequent process may have improved stability.

In some embodiments, the first transistor TR1 may have a structure similar to that of the transistor TRc discussed in FIG. 8. In some embodiments, the second transistor TR2 may have a structure similar to that of the transistor TRb discussed in FIG. 7 or that of the transistor TRd discussed in FIG. 9.

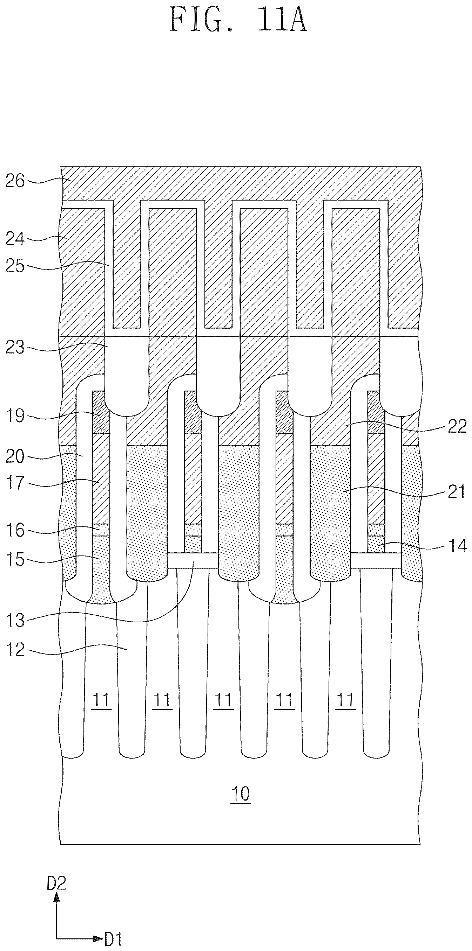

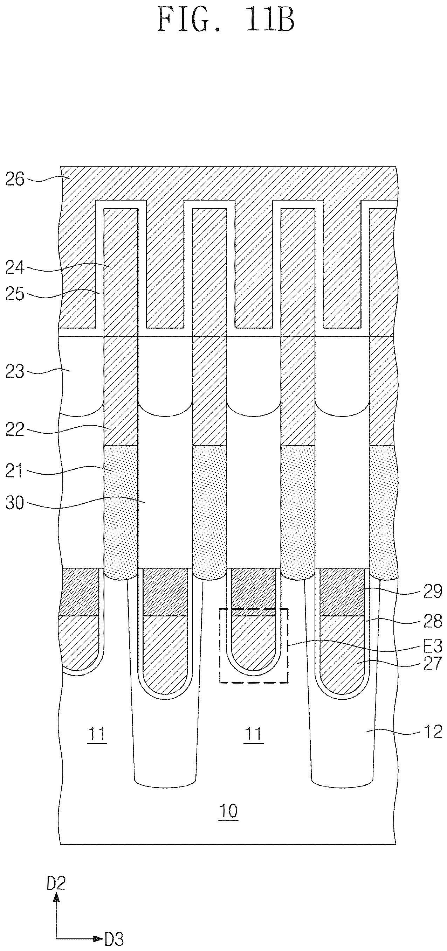

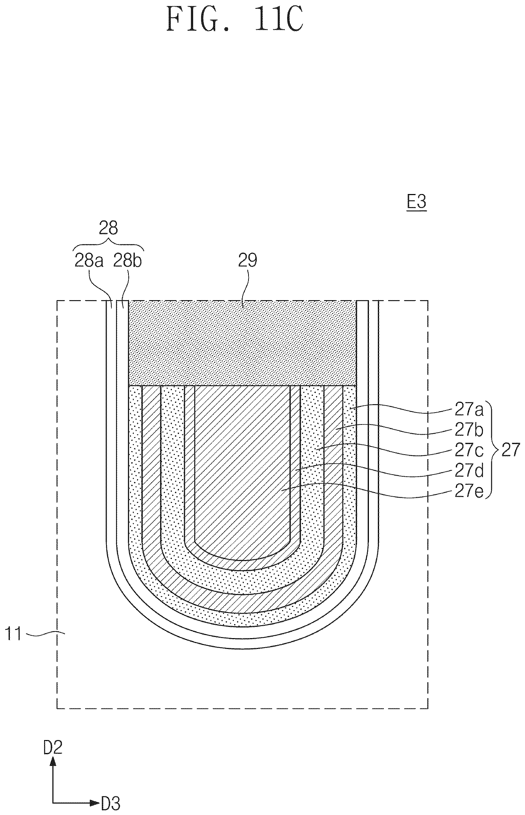

FIGS. 11A and 11B illustrate cross-sectional views showing a semiconductor device according to some embodiments. FIG. 11C illustrates an enlarged view showing section E3 of FIG. 11B.

Referring to FIGS. 11A and 11B, a semiconductor device may include a substrate 10, active patterns 11, cell device isolation layers 12, cell dielectric layers 13, bit-line contacts 15, first bit-line conductive layers 14, second bit-line conductive layers 16, third bit-line conductive layers 17, bit-line capping layers 19, bit-line spacers 20, node contacts 21, landing pads 22, a landing pad isolation layer 23, first cell capacitor electrodes 24, a cell capacitor dielectric layer 25, a second cell capacitor electrode 26, cell gate electrodes 27, cell gate dielectric layers 28, cell gate capping layers 29, and dielectric fences 30.

The active patterns 11 may be defined to refer to upper portions of the substrate 10 that protrude upward in a second direction D2. The active patterns 11 may be spaced apart from each other.

The cell device isolation layers 12 may be provided in a space between the active patterns 11. The active patterns 11 may be defined by the cell device isolation layers 12. The cell device isolation layer 12 may include a dielectric material.

A gate structure may be provided which includes the cell gate electrode 27, the cell gate dielectric layer 28, and the cell gate capping layer 29. The gate structures may extend in a first direction D1. The gate structures may be arranged in a third direction D3. The third direction D3 may intersect the first direction D1 and the second direction D2. For example, the third direction D3 may be a horizontal direction orthogonal to the first direction D1 and the second direction D2.

The gate structure may be a buried gate structure that is buried in the active patterns 11 and the cell device isolation layer 12. The cell gate capping layer 29 may include a dielectric material.

The cell dielectric layers 13 may be provided on the gate structures and the cell device isolation layers 12. The cell dielectric layer 13 may include a dielectric material. In some embodiments, the cell dielectric layer 13 may include a plurality of dielectric layers.

Bit-line structures may be provided which extend in the third direction D3. The bit-line structures may be arranged in the first direction D1. The bit-line structure may include the bit-line contacts 15, the first bit-line conductive layers 14, the second bit-line conductive layer 16, the third bit-line conductive layer 17, the bit-line capping layer 19, and the bit-line spacer 20.

The bit-line contacts 15 and the first bit-line conductive layers 14 of the bit-line structure may be alternately disposed along the third direction D3. The bit-line contact 15 may be connected to the active pattern 11. The first bit-line conductive layer 14 may be provided on the cell dielectric layer 13.

The second bit-line conductive layer 16 may be provided on the bit-line contacts 15 and the first bit-line conductive layers 14. The third bit-line conductive layer 17 may be provided on the second bit-line conductive layer 16. The bit-line capping layer 19 may be provided on the third bit-line conductive layer 17. The bit-line contact 15, the first bit-line conductive layer 14, the second bit-line conductive layer 16, and the third bit-line conductive layer 17 may include a conductive material. The bit-line capping layer 19 may include a dielectric material.

The bit-line spacer 20 may cover a top surface and a sidewall of the bit-line capping layer 19, sidewalls of the first, second, and third bit-line conductive layers 14, 16, and 17, and sidewalls of the bit-line contacts 15. The bit-line spacer 20 may include a dielectric material. In some embodiments, the bit-line spacer 20 may include a plurality of dielectric layers.

The node contact 21 may be connected to the active pattern 11. The node contact 21 may be provided between neighboring bit-line structures. The node contact 21 may include a conductive material. For example, the node contact 21 may include polysilicon.

The landing pad 22 may be provided on the node contact 21. The landing pad 22 may include a conductive material. In some embodiments, a metal silicide layer and a barrier layer may be provided between the node contact 21 and the landing pad 22.

The dielectric fence 30 may be provided on the cell gate capping layer 29. The dielectric fence 30 may be provided between neighboring node contacts 21. The dielectric fence 30 may include a dielectric material.

The landing pad isolation layer 23 may be provided on the dielectric fence 30. The landing pad isolation layer 23 may separate the landing pads 22 from each other. The landing pad isolation layer 23 may surround the landing pad 22. The landing pad isolation layer 23 may include a dielectric material.

A cell capacitor may be constituted by the first cell capacitor electrode 24, the cell capacitor dielectric layer 25, and the second cell capacitor electrode 26. The cell capacitor dielectric layer 25 may be provided between the first cell capacitor electrode 24 and the second cell capacitor electrode 26. The first and second cell capacitor electrodes 24 and 26 may include a conductive material. The cell capacitor dielectric layer 25 may include a dielectric material. The semiconductor device may be a dynamic random access memory (DRAM) including the cell capacitor.

In some embodiments, a memory cell structure may include a magnetic tunnel junction pattern instead of the cell capacitor. In this case, the semiconductor device may be a magnetic tunnel junction pattern (MRAM). In some embodiments, the memory cell structure may include a phase change material or a variable resistance material instead of the cell capacitor. In this case, the semiconductor device may be a phase change random access memory (PRAM) or a resistive random access memory (ReRAM). In some embodiments, various structures and/or materials instead of the cell capacitor may be provided to store data.

Referring to FIG. 11C, the cell gate dielectric layer 28 may include a gate dielectric layer 28a and a high-k dielectric layer 28b. The cell gate electrode 27 may include a dipole structure 27a, a metal pattern 27b, a first conductive layer 27c, a second conductive layer 27d, and a third conductive layer 27e. The dipole structure 27a may include a first dipole layer and a second dipole layer, and a first dipole element of the first dipole layer and a second dipole element of the second dipole layer may be different in terms of a maximum oxidation number.

In some embodiments, the dipole structure 27a and the high-k dielectric layer 28b may be provided therebetween with other metal pattern whose work function is different from that of the metal pattern 27b.

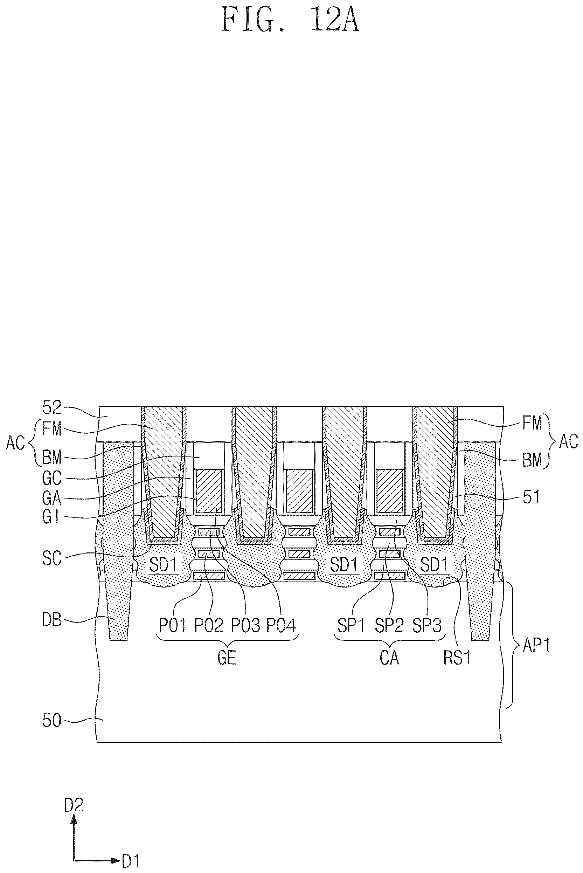

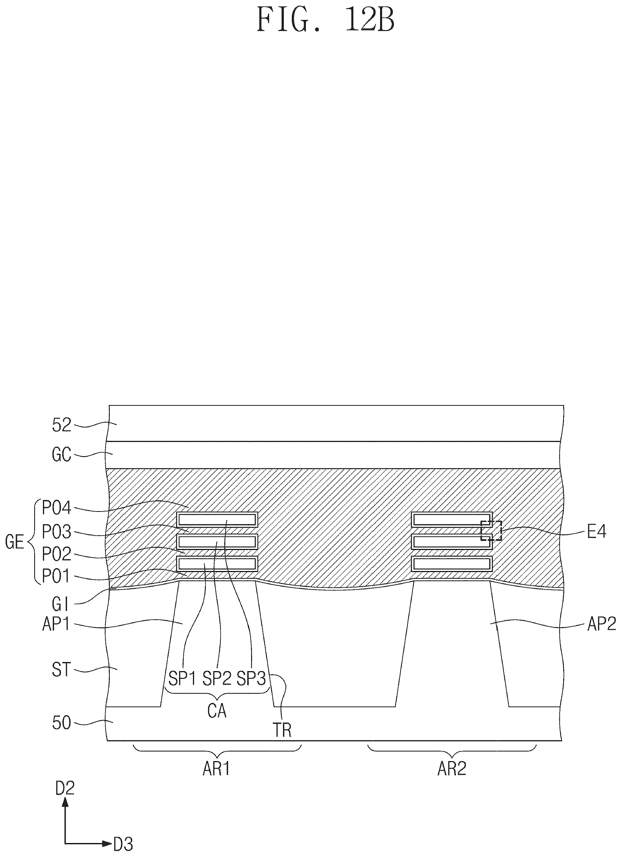

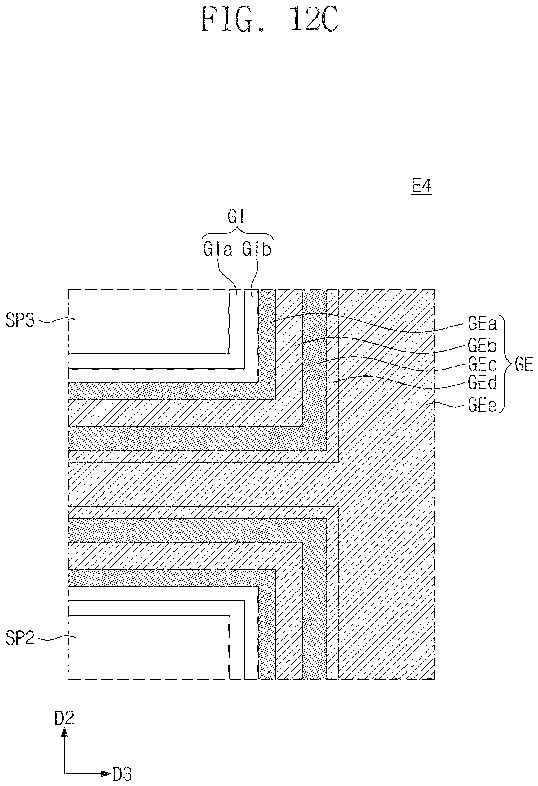

FIGS. 12A and 12B illustrate cross-sectional views showing a semiconductor device according to some embodiments. FIG. 12C illustrates an enlarged view showing section E4 of FIG. 12B.

Referring to FIGS. 12A and 12B, a semiconductor device may include a substrate 50. The substrate 50 may be provided thereon with logic transistors included in a logic circuit.

The substrate 50 may include a first active pattern AP1 and a second active pattern AP2. The first active pattern AP1 and the second active pattern AP2 may be defined by a trench TR on the substrate 50. The first and second active patterns AP1 and AP2 may extend in a first direction D 1. The first and second active patterns AP1 and AP2 may be portions of the substrate 50 that protrude upward in a second direction D2.

A device isolation layer ST may be provided on the substrate 50. The device isolation layer ST may fill the trench TR. The device isolation layer ST may include a dielectric material.

Channel patterns CA may be provided on the first active pattern AP1 and the second active pattern AP2. The channel pattern CA may include a first semiconductor pattern SP1, a second semiconductor pattern SP2, and a third semiconductor pattern SP3 that are sequentially arranged in the second direction D2. The first, second, and third semiconductor patterns SP1, SP2, and SP3 may be spaced apart from each other in a third direction D3.

In some embodiments, the first, second, and third semiconductor patterns SP1, SP2, and SP3 may include silicon (Si). For example, each of the first, second, and third semiconductor patterns SP1, SP2, and SP3 may include crystalline silicon. In some embodiments, the first, second, and third semiconductor patterns SP1, SP2, and SP3 may include silicon-germanium (SiGe).

A plurality of source/drain patterns SD1 may be provided on each of the first active pattern AP1 and the second active pattern AP2. A plurality of recesses RS1 may be formed on each of the first active pattern AP1 and the second active pattern AP2. The source/drain patterns SD1 may be correspondingly provided in the recesses RS1. A channel pattern CA may be interposed between neighboring source/drain patterns SD1. The source/drain patterns SD1 may be epitaxial patterns formed by a selective epitaxial growth (SEG) process.

A plurality of gate electrodes GE may be provided which extend in the third direction D3. The gate electrode GE may include a first part PO1 interposed between the active pattern AP1 or AP2 and the first semiconductor pattern SP1, a second part PO2 interposed between the first semiconductor pattern SP1 and the second semiconductor pattern SP2, a third part PO3 interposed between the second semiconductor pattern SP2 and the third semiconductor pattern SP3, and a fourth part PO4 on the third semiconductor pattern SP3.

The gate electrode GE and the first, second, and third semiconductor patterns SP1, SP2, and SP3 three-dimensionally surrounded by the gate electrode GE may constitute a three-dimensional field effect transistor (e.g., NMCFET or GAAFET).

A pair of gate spacers GA may be disposed on opposite sidewalls of the gate electrode GE. A gate capping pattern GC may be provided on the gate electrode GE.

A plurality of cell gate dielectric layers GI may be provided. The cell gate dielectric layer GI may separate the gate electrode GE from the channel pattern CA. The cell gate dielectric layer GI may three-dimensionally surround the first, second, and third semiconductor patterns SP1, SP2, and SP3. The cell gate dielectric layer GI may cover the device isolation layer ST. The cell gate dielectric layer GI may include a dielectric material. For example, the cell gate dielectric layer GI may include oxide.

A first interlayer dielectric layer 51 may be provided to cover the gate spacers GA and the source/drain patterns SD1. A second interlayer dielectric layer 52 may be formed on the first interlayer dielectric layer 51 and the gate capping pattern GC. The first and second interlayer dielectric layers 51 and 52 may include a dielectric material.

A plurality of separation structures DB may be provided. The separation structure DB may extend in the third direction D3. The gate electrodes GE may be disposed between the separation structures DB.

The separation structure DB may be in (e.g., may penetrate) the first and second interlayer dielectric layers 51 and 52 to extend into the first and second active patterns AP1 and AP2. A lower portion of the separation structure DB may extend (e.g., may penetrate) in the third direction D3 through an upper portion of each of the first and second active patterns AP1 and AP2.

An active contact AC may be in (e.g., may be provided to penetrate) the first and second interlayer dielectric layers 51 and 52 to come into electrical connection with the source/drain pattern SD1. The gate electrode GE may be provided between neighboring active contacts AC.

A metal-semiconductor compound layer SC may be provided. The metal-semiconductor compound layer SC may be interposed between the active contact AC and the source/drain pattern SD1.

The active contact AC may be electrically connected through the metal-semiconductor compound layer SC to the source/drain pattern SD1. For example, the metal-semiconductor compound layer SC may include at least one selected from titanium silicide, tantalum silicide, tungsten silicide, nickel silicide, and cobalt silicide.

The active contact AC may include a conductive pattern FM and a barrier pattern BM that surrounds the conductive pattern FM. For example, the conductive pattern FM may include at least one selected from aluminum, copper, tungsten, molybdenum, and cobalt. The barrier pattern BM may cover sidewalls and a bottom surface of the conductive pattern FM. The barrier pattern BM may include at least one selected from a metal layer and a metal nitride layer. The metal layer may include, for example, at least one selected from titanium, tantalum, tungsten, nickel, cobalt, and platinum. The metal nitride layer may include at least one selected from a titanium nitride (TiN) layer, a tantalum nitride (TaN) layer, a tungsten nitride (WN) layer, a nickel nitride (NiN) layer, a cobalt nitride (CoN) layer, and a platinum nitride (PtN) layer.

Referring to FIG. 12C, the cell gate dielectric layer GI may include a gate dielectric layer GIa and a high-k dielectric layer GIb. The gate electrode GE may include a dipole structure GEa, a metal pattern GEb, a first conductive layer GEc, a second conductive layer GEd, and a third conductive layer GEe. The dipole structure GEa may include a first dipole layer and a second dipole layer, and a first dipole element of the first dipole layer and a second dipole element of the second dipole layer may have different maximum oxidation numbers.

In some embodiments, the dipole structure GEa and the high-k dielectric layer GIb may have/be provided therebetween another metal pattern whose work function is different from that of the metal pattern GEb.

A semiconductor device according to some embodiments of the present inventive concepts may include a dipole structure to adjust a threshold voltage of a transistor and to decrease a size of the transistor.

Although the present invention has been described in connection with some embodiments of the present inventive concepts illustrated in the accompanying drawings, it will be understood by one of ordinary skill in the art that variations in form and detail may be made therein without departing from the scope of the present inventive concepts. The above disclosed embodiments should thus be considered illustrative and not restrictive. Moreover, the embodiments discussed above may be combined with each other if necessary.

## Claims

1. A semiconductor device comprising:
a first channel region;
a first dielectric structure on the first channel region;
a first metal pattern spaced apart from the first dielectric structure; and
a first dipole structure between the first metal pattern and the first dielectric structure,
wherein the first dipole structure includes a first dipole layer and a second dipole layer,
wherein the first dipole layer includes a first dipole element,
wherein the second dipole layer includes a second dipole element different from the first dipole element, and
wherein a maximum oxidation number of the first dipole element is different from a maximum oxidation number of the second dipole element.

2. The semiconductor device of claim 1,
wherein the first dipole layer is in contact with the first metal pattern, and
wherein the second dipole layer is in contact with the first dielectric structure.

3. The semiconductor device of claim 2, wherein the maximum oxidation number of the first dipole element is greater than the maximum oxidation number of the second dipole element.

4. The semiconductor device of claim 2, wherein the maximum oxidation number of the second dipole element is greater than the maximum oxidation number of the first dipole element.

5. The semiconductor device of claim 1, further comprising a second metal pattern between the first dielectric structure and the first dipole structure.

6. The semiconductor device of claim 5, wherein a thickness of the second metal pattern is less than a thickness of the first metal pattern.

7. The semiconductor device of claim 1, further comprising:
a second channel region;
a second dielectric structure on the second channel region;
a second metal pattern spaced apart from the second dielectric structure;
a second dipole structure between the second metal pattern and the second dielectric structure,
wherein the first channel region includes an impurity having a first conductivity type,
wherein the second channel region includes an impurity having a second conductivity type different from the first conductivity type, and
wherein the second dipole structure includes:
a third dipole layer that includes the first dipole element; and
a fourth dipole layer that includes the second dipole element.

8. The semiconductor device of claim 7,
wherein the first dipole structure is in contact with the first dielectric structure,
wherein the second dipole structure is spaced apart from the second dielectric structure, and
wherein a third metal pattern between the second dipole structure and the second dielectric structure.

9. The semiconductor device of claim 8, wherein a work function of the second metal pattern is less than a work function of the third metal pattern.

10. The semiconductor device of claim 8,
wherein a work function of the second metal pattern is less than a mid-gap work function of the second channel region, and
wherein a work function of the third metal pattern is greater than the mid-gap work function of the second channel region.

11. The semiconductor device of claim 1, further comprising a conductive layer spaced apart from the first dipole structure,
wherein the first metal pattern is between the first dipole structure and the conductive layer,
wherein the conductive layer includes polysilicon, and
wherein the first dipole structure is configured to provide, at an interface of the first dipole layer and the second dipole layer, an interface dipole that adjusts a threshold voltage of the semiconductor device.

12. The semiconductor device of claim 1, further comprising a second metal pattern between the first dipole structure and the first dielectric structure, and
wherein a work function of the second metal pattern is greater than a work function of the first metal pattern.

13. The semiconductor device of claim 1, further comprising:
a second metal pattern on the first metal pattern;
a conductive structure on the second metal pattern; and
a gate capping pattern on the conductive structure.

14. The semiconductor device of claim 13, wherein a work function of the second metal pattern is greater than a work function of the first metal pattern.

15. The semiconductor device of claim 1, further comprising:
a substrate; and
a semiconductor layer on the substrate,
wherein the semiconductor layer is between the first dielectric structure and the substrate, and
wherein the substrate and the semiconductor layer include different semiconductor materials from each other.
